# EUROPEAN PATENT APPLICATION

(11) **EP 3 128 552 A1**
(43) Date of publication of application: **08.02.2017**
(21) Application number: 14887860.6
(22) Date of filing: 08.08.2014
(51) Int. Cl.: H01L 23/49

(54) **WAFER CIRCUIT**

(30) Priority: 04.04.2014 CN 201410137106
(71) Applicant: Leyard Optoelectronic Co., Ltd, Beijing 100091 (CN)
(72) Inventor: LU, Changjun, Beijing 100091 (CN); PAN, Tong, Beijing 100091 (CN); YU, Jie, Beijing 100091 (CN)
(74) Representative: Inchingalo, Simona
(86) International application number: PCT/CN2014/084027
(87) International publication number: WO 2015/149462

(57) **Abstract**

A wafer circuit, including: a wafer (10), fixed on a substrate; an electrode (20), arranged on the wafer (10); a bonding pad (30), arranged on the substrate; and a plurality of bonding wires (40) with first ends all connected to the electrode (20) and second ends all connected to the bonding pad (30), wherein the plurality of bonding wires (40) are parallel bonding wires.

## Description

### Technical field of the invention

The present invention relates to the field of circuits, particularly to a wafer circuit.

### Background of the invention

A wafer is a raw material of a Light Emitting Diode (LED) and the LED mainly relies on the wafer to emit lights. The wafer is equivalent to a PN junction formed by a P type material and an N type material. Energy will be released in the form of photons when holes of the P type material are recombined with electrons of the N type material, thereby enabling the LED to emit lights.

In a wafer circuit of the prior art, one electrode on the wafer corresponds to one bonding pad and the electrode and the bonding pad are connected by a bonding wire to form a circuit. In this way, the wafer circuit will become abnormal when the bonding wire is damaged, and a PN junction of a wafer will not be conducted, nor will holes be recombined with electrons, thus affecting normal use of an LED.

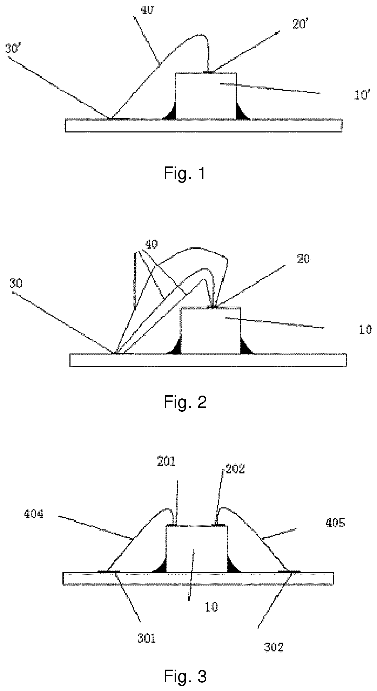

As shown in Fig. 1, the wafer circuit includes a wafer 10', an electrode 20', a bonding pad 30', and a bonding wire 40', wherein the electrode 20' is arranged on the wafer 10', and the electrode 20' is connected to the bonding pad 30'via the bonding wire 40'. Both the bonding pad 30' and the wafer 10'are arranged on a substrate. Thus, the whole wafer circuit will become abnormal once the bonding wire 40' is damaged.

At present, there is no effective solution yet to solve the problem that a wafer circuit is easy to become abnormal in the related art.

### Summary of the invention

The major purpose of the present invention is to provide a wafer circuit so as to solve the problem in the related art that a wafer circuit is easy to become abnormal.

A wafer circuit is provided according to the present invention so as to implement the purpose above. The wafer circuit includes: a wafer, fixed on a substrate; an electrode, arranged on the wafer; a bonding pad, arranged on the substrate; and a plurality of bonding wires with first ends all connected to the electrode and second ends all connected to the bonding pad, wherein the plurality of bonding wires are parallel bonding wires.

Further, the electrode is one electrode and the bonding pad is one bonding pad, and that the first ends of the plurality of bonding wires are all connected to the electrode and the second ends of the plurality of bonding wires are all connected to the bonding pad includes that the first ends of the plurality of bonding wires are all connected to the one electrode and the second ends of the plurality of bonding wires are all connected to the one bonding pad.

Further, the electrode is one electrode and the bonding pad is a plurality of bonding pads, and that the first ends of the plurality of bonding wires are all connected to the electrode and the second ends of the plurality of bonding wires are all connected to the bonding pad includes that the first ends of the plurality of bonding wires are all connected to the one electrode and the second ends of the plurality of bonding wires are connected to any bonding pad among the plurality of bonding pads.

Further, the electrode is one electrode and the bonding pad is a plurality of bonding pads, and that the first ends of the plurality of bonding wires are all connected to the electrode and the second ends of the plurality of bonding wires are all connected to the bonding pad includes that the first ends of the plurality of bonding wires are all connected to the one electrode and the second ends of the plurality of bonding wires are connected to different bonding pads among the plurality of bonding pads.

Further, the electrode includes a first electrode and a second electrode, the bonding pad includes a first bonding pad and a second bonding pad, and the plurality of bonding wires include a first bonding wire and a second bonding wire, and that the first ends of the plurality of bonding wires are all connected to the electrode and the second ends of the plurality of bonding wires are all connected to the bonding pad includes that a first end of the first bonding wire is connected to the first electrode, a second end of the first bonding wire is connected to the first bonding pad, a first end of the second bonding wire is connected to the second electrode and a second end of the second bonding wire is connected to the second bonding pad.

Further, the electrode is a plurality of electrodes, and the bonding pad is one bonding pad, and that the first ends of the plurality of bonding wires are all connected to the electrode and the second ends of the plurality of bonding wires are all connected to the bonding pad includes that the first ends of the plurality of bonding wires are connected to any electrode among the plurality of electrodes, and the second ends of the plurality of bonding wires are all connected to the one bonding pad.

Further, the electrode is a plurality of electrodes, and the bonding pad is one bonding pad, and that the first ends of the plurality of bonding wires are all connected to the electrode and the second ends of the plurality of bonding wires are all connected to the bonding pad includes that the first ends of the plurality of bonding wires are connected to different electrodes among the plurality of electrodes and the second ends of the plurality of bonding wires are all connected to the one bonding pad.

Further, the electrode is a plurality of electrodes, and the bonding pad is a plurality of bonding pads, and that the first ends of the plurality of bonding wires are all connected to the electrode and the second ends of the plurality of bonding wires are all connected to the bonding pad includes that the first ends of the plurality of bonding wires are connected to any electrode among the plurality of electrodes, and the second ends of the plurality of boding wires are connected to any bonding pad among the plurality of bonding pads.

Further, the electrode is a plurality of electrodes, and the bonding pad is a plurality of bonding pads, and that the first ends of the plurality of bonding wires are all connected to the electrode and the second ends of the plurality of bonding wires are all connected to the bonding pad includes that the first ends of the plurality of bonding wires are connected to different electrodes among the plurality of electrodes and the second ends of the plurality of bonding wires are connected to different bonding pads among the plurality of bonding pads.

Further, the electrode is a plurality of electrodes, and the bonding pad is a plurality of bonding pads, and that the first ends of the plurality of bonding wires are all connected to the electrode and the second ends of the plurality of bonding wires are all connected to the bonding pad includes that the first ends of the plurality of bonding wires are connected to any electrode among the plurality of electrodes and the second ends of the plurality of bonding wires are connected to different bonding pads among the plurality of bonding pads.

Further, the electrode is a plurality of electrodes, and the bonding pad is a plurality of bonding pads, and that the first ends of the plurality of bonding wires are all connected to the electrode and the second ends of the plurality of bonding wires are all connected to the bonding pad includes that the first ends of the plurality of bonding wires are connected to different electrodes among the plurality of electrodes and the second ends of the plurality of bonding wires are connected to any bonding pad among the plurality of bonding pads.

Further, the electrodes are arranged at a P type material side of the wafer simultaneously, or arranged at an N type material side of the wafer simultaneously.

The present invention applies a wafer, fixed on a substrate; an electrode, arranged on the wafer; a bonding pad, arranged on the substrate; and a plurality of bonding wires with first ends all connected to the electrode and second ends all connected to the bonding pad, wherein the plurality of bonding wires are parallel bonding wires, thus the electrode and the bonding pad will not be disconnected even if a certain bonding wire or some bonding wires are damaged, thereby solving the problem in the related art that a wafer circuit is easy to become abnormal and further achieving the effect of reducing the probability that the wafer circuit becomes abnormal.

### Brief description of the drawings

The accompanying drawings, which constitute a part of the application, are used for providing further understanding to the present invention. The exemplary embodiments of the present invention and illustration thereof are used for explaining the present invention, instead of constituting improper limitation to the present invention. In the accompanying drawings:
Fig. 1 is a schematic diagram of a wafer circuit according to the related art;
Fig. 2 is a schematic diagram of a wafer circuit according to an embodiment of the present invention; and
Fig. 3 is a schematic diagram of a wafer circuit according to a preferred embodiment of the present invention.

### Detailed description of the embodiments

It needs to be noted that the embodiments in the application and the characteristics in the embodiments may be combined with each other if there is no conflict. The present invention will be expounded hereinafter with reference to the accompanying drawings and in combination with the embodiments.

The technical solutions in the embodiments of the present invention will be described clearly and completely hereinafter with reference to the accompanying drawings in the embodiments of the present invention so that those skilled in the art may better understand the solutions of the present invention. Evidently, the described embodiments are merely some embodiments rather than all embodiments of the present invention. All other embodiments obtained by persons of ordinary skill in the art based on the embodiments in the present invention without creative efforts shall belong to the protection scope of the present invention.

It needs to be noted that the terms "first", "second" and so on in the specification, the claims and the accompanying drawings of the present invention are used for distinguishing similar objects, but are not necessarily used for describing a specific sequence or a precedence order. It should be understood that data used in this way are interchangeable in an appropriate condition, so that the embodiments described herein of the present invention can be implemented in a sequence besides those illustrated or described herein. In addition, the terms "include" and "have" and any other variants of them are intended to cover non-exclusive inclusion.

A wafer circuit is provided according to an embodiment of the present invention. The wafer circuit is used for utilizing a plurality of bonding wires to reduce the probability that a wafer circuit becomes abnormal.

Fig. 2 is a schematic diagram of a wafer circuit according to an embodiment of the present invention. As shown in Fig. 2, the wafer circuit includes: a wafer 10, an electrode 20, a bonding pad 30, and a bonding wire 40, wherein the bonding wire 40 includes any number of bonding wires, and three bonding wires 40 are described in the present embodiment.

The wafer 10 is fixed on a substrate, wherein the wafer 10 may be fixed on the substrate by glue. The glue may be silver glue or insulating cement and the substrate may be a Printed Circuit Board (PCB).

The electrode 20 is arranged on the wafer 10. Specifically, the electrode 20 may include one or more. When there is one electrode 20, the electrode may be arranged on a P type material side or an N type material side of the wafer 10. When there is a plurality of electrodes 20, the plurality of electrodes 20 may be arranged on the P type material side of the wafer 10 simultaneously, or arranged on the N type material side of the wafer 10 simultaneously.

The bonding pad 30 is arranged on the substrate, wherein there may be one or more bonding pads 30. When there is one bonding pad 30, the plurality of bonding wires 40 connected between the electrode 20 and the bonding pad 30 are necessarily parallel bonding wires. When there is a plurality of bonding pads 30, the plurality of bonding pads 30 may be connected via the bonding wires on the substrate, thus the plurality of bonding wires 40 between the plurality of bonding pads 30 and the electrode 20 are parallel bonding wires.

First ends of the plurality of bonding wires 40 are all connected to the electrode 20, and second ends of the plurality of bonding wires 40 are all connected to the bonding pad 30, wherein the plurality of bonding wires 40 are parallel bonding wires. In the present embodiment, the three bonding wires are bonding wire 401, bonding wire 402 and bonding wire 403, respectively. First ends of the three bonding wires are all connected to the electrode 20 and second ends of the three bonding wires are all connected to the bonding pad 30.

In an embodiment of the present invention, the electrode 20 may be only one kind of electrode 20 arranged on the wafer 10, i.e. a first electrode. If the electrode 20 is arranged at the P type material side of the wafer 10, the polarity of the electrode 20 is "+" and the electrode may be connected to the "+" pole on the substrate via the plurality of bonding wires 30, while the N type material side of the wafer 10 may be connected with the "-" pole on the substrate directly. In this way, a PN junction of the wafer 10 may be conducted after a power source is turned on, so as to recombine holes and electrons and release energy in the form of photons to enable an LED to emit lights. Of course, if the electrode 20 is arranged at the N type material side of the wafer 10, the polarity of the electrode 20 is "-" and the electrode may be connected to the "-" pole on the substrate through the plurality of bonding wires 30, while the P type material side of the wafer 10 may be connected with the "+" pole on the substrate directly. In this way, a PN junction of the wafer 10 may be conducted when a power source is turned on so as to recombine holes and electrons and release energy in the form of photons to enable an LED to emit lights.

In addition, a second electrode may be also arranged on the wafer 10 besides one electrode, i.e. the electrode 20 (the first electrode) in an embodiment of the present invention. At the moment, if the electrode 20 is arranged at the P type material side of the wafer 10, the polarity of the electrode 20 is "+" and the electrode may be connected to the "+" pole on the substrate via the plurality of bonding wires 30, while the second electrode may be connected with the "-" pole on the substrate. In this way, a PN junction of the wafer 10 may be conducted after a power source is turned on, so as to recombine holes and electrons and release energy in the form of photons to enable an LED to emit lights. Of course, if the electrode 20 is arranged at the N type material side of the wafer 10, the polarity of the electrode 20 is "-", and the electrode may be connected to the "-" pole on the substrate through the plurality of bonding wires 30, while the second electrode may be connected with the "+" pole on the substrate. In this way, a PN junction of the wafer 10 may be conducted when the power source is turned on so as to recombine holes and electrons and release energy in the form of photons to enable an LED to emit lights.

By means of the embodiments of the present invention, a plurality of bonding wires 40 are connected between an electrode 20 and a bonding pad 3. In this way, a wafer circuit will not become abnormal as long as at least one bonding wire 40 is connected between the electrode 20 and the bonding pad 30 if some bonding wires 40 in one or more bonding wires 40 are damaged, thereby achieving the effect of reducing the probability that the wafer circuit becomes abnormal.

It needs to be noted that there may be one or more electrodes 20 and bonding pads 30 in the embodiments of the present invention. If there is a plurality of electrodes 20 and/or bonding pads 30, an abnormality of the wafer circuit, which is caused by damage of an electrode 20 and/or separation of a bonding pad 30, may be avoided. Multilayer protection may be provided for the wafer circuit by arranging a plurality of bonding wires 40 and/or a plurality of electrodes 20 and/or a plurality of bonding pads 30 in the wafer circuit, thereby preventing the wafer circuit from becoming abnormal due to reasons including damage of a bonding wire 40 and/or damage of an electrode and/or separation of a bonding pad 30, and so on, wherein combining methods and corresponding connection methods of an electrode 20 and a bonding pad 30 in the wafer circuit may be as follows in the case that there may be one or more electrodes 20 and bonding pads 30.

In the first method, when the electrode 20 is one electrode and the bonding pad 30 is also one bonding pad, the first ends of the plurality of bonding wires 40 may be all connected on the same electrode 20 and the second ends of the plurality of bonding wires 40 may be all connected on the same bonding pad 40, and after being connected in this way, the plurality of bonding wires 40 are necessarily parallel bonding wires. Since the electrode 20 and the bonding pad 30 are connected by the plurality of bonding wires 40, it may be ensured that the electrode 20 and the bonding pad 30 are connected as long as there is an undamaged bonding wire 40 between the electrode 20 and the bonding pad 30 regardless of a damaged bonding wire 40, thereby ensuring that the wafer circuit is normal.

In the second method, when the electrode 20 is one electrode and the bonding pad 30 is a plurality of bonding pads, wherein the plurality of bonding pad 30 are respectively arranged on different locations of the substrate, the first ends of the plurality of bonding wires 40 may be all connected on the same electrode 20 and the second ends of the plurality of bonding wires 40 may be all connected to any bonding pad 30 among the plurality of bonding pads 30. It needs to be noted that the plurality of bonding wires 40 connected on any bonding pad 30 are parallel bonding wires. Since the electrode 20 and the bonding pads 30 are connected by the plurality of bonding wires 40, it may be ensured that the electrode 20 and the bonding pads 30 are connected as long as there is an undamaged bonding wire 40 between the electrode 20 and the bonding pads 30 regardless of a damaged bonding wire 40, thereby ensuring that the wafer circuit is normal. In the meanwhile, since the plurality of parallel bonding wires 40 may be connected on the plurality of bonding pads 30, the normality of the whole wafer circuit will not be affected even if a bonding pad 30 is separated.

In the third method, when the electrode 20 is one electrode and the bonding pad 30 is a plurality of bonding pads, wherein the plurality of bonding pad 30 are respectively arranged on different locations of the substrate, the first ends of the plurality of bonding wires 40 may be all connected on the same electrode 20 and the second ends of the plurality of bonding wires may be connected to different bonding pads 30 among the plurality of bonding pads 30. It needs to be noted that the plurality of bonding wires 40 connected on different bonding pads 30 are parallel bonding wires. Based on the same reason as that in the second method (which will not be described repeatedly here), the normality of the whole wafer circuit will not be affected even if a bonding pad 30 is separated.

In the fourth method, when the electrode 20 includes a first electrode 201 and a second electrode 202, the bonding pad 30 includes a first bonding pad 301 and a second bonding pad 302, and the plurality of bonding wires 40 include a first bonding wire 404 and a second bonding wire 405, wherein the first electrode and the second electrode are arranged at the P type material side or the N type material side of the wafer 10 simultaneously, or the two are on different locations, and the first bonding pad and the second bonding pad are arranged on different locations of the substrate respectively, a first end of the first bonding wire may be connected to the first electrode, a second end of the first bonding wire may be connected to the first bonding pad, a first end of the second bonding wire may be connected to the second electrode and a second end of the second bonding wire may be connected to the second bonding pad. The first bonding wire and the second bonding wire are parallel bonding wires. Since the first bonding wire and the second bonding wire, which are parallel with each other, are connected between the first electrode and first bonding pad, and between the second electrode and the second bonding pad, respectively, the whole wafer circuit will not become abnormal as long as either or both of the first bonding wire and the second bonding wire are undamaged. In the meanwhile, since different bonding wires are connected to different electrodes and bonding pads, the whole wafer circuit will not become abnormal even if one electrode or one bonding pad is damaged, thus multilayer protection is provided for the wafer circuit by the electrodes 20, the bonding pads 30 and the bonding wires 40, as shown in Fig. 3.

In the fifth method, when the electrode 20 is a plurality of electrodes, while the bonding pad 30 is one bonding pad, the first ends of the plurality of bonding wires 40 may be connected to any electrode among the plurality of electrodes 20, and the second ends of the plurality of bonding wires 40 may be all connected to the same bonding pad 30, wherein the plurality of bonding wires 40 are parallel bonding wires. Since the electrodes 20 and the bonding pad 30 are connected by the plurality of bonding wires 40, it may be ensured that the electrodes 20 and the bonding pad 30 are connected as long as there is an undamaged bonding wire 40 between the electrodes 20 and the bonding pad 30 regardless of a damaged bonding wire 40, thereby ensuring that the wafer circuit is normal. In the meanwhile, since the plurality of parallel bonding wires 40 may be connected on the plurality of electrodes 20, the normality of the whole wafer circuit will not be affected even if an electrode 20 is damaged.

In the sixth method, when the electrode 20 is a plurality of electrodes, and the bonding pad 30 is one bonding pad, the first ends of the plurality of bonding wires 40 may be connected to different electrodes among the plurality of electrodes 20 and the second ends of the plurality of bonding wires 40 may be connected on the same bonding pad 30, wherein the plurality of bonding wires 40 are parallel bonding wires. Based on the same reason as that in the fifth method (which will not be described repeatedly here), the normality of the whole wafer circuit will not be affected even if an electrode 20 is damaged.

In the seventh embodiment, when the electrode 20 is a plurality of electrodes, and the bonding pad 30 is also a plurality of bonding pads, the first ends of the plurality of bonding wires 40 may be connected to any electrode among the plurality of electrodes 20, and the second ends of the plurality of boding wires may be connected to any bonding pad among the plurality of bonding pads 30, wherein the plurality of bonding wires 40 are parallel bonding wires. Based on the same reason as those in the second method and the fifth method (which will not be described repeatedly here), the normality of the whole wafer circuit will not be affected even if an electrode 20 is damaged, or a bonding pad 30 is separated or a bonding wire 40 is damaged.

In the eighth method, when the electrode 20 is a plurality of electrodes, and the bonding pad 30 is a plurality of bonding pads, the first ends of the plurality of bonding wires 40 are connected to different electrodes among the plurality of electrodes 20 and the second ends of the plurality of bonding wires 40 are connected to different bonding pads among the plurality of bonding pads 30, wherein the plurality of bonding wires 40 are parallel bonding wires. Based on the same reason as that in the seventh embodiment (which will not be described repeatedly here), the normality of the whole wafer circuit will not be affected even if an electrode 20 is damaged, or a bonding pad 30 is separated or a bonding wire 40 is damaged.

In the ninth embodiment, when the electrode 20 is a plurality of electrodes, and the bonding pad 30 is a plurality of bonding pads, the first ends of the plurality of bonding wires 40 may be connected to any electrode among the plurality of electrodes 20 and the second ends of the plurality of bonding wires 40 may be connected to different bonding pads among the plurality of bonding pads 30. Based on the same reason as that in the seventh embodiment (which will not be described repeatedly here), the normality of the whole wafer circuit will not be affected even if an electrode 20 is damaged, or a bonding pad 30 is separated or a bonding wire 40 is damaged.

In the tenth embodiment, when the electrode 20 is a plurality of electrodes, and the bonding pad 30 is a plurality of bonding pads, the first ends of the plurality of bonding wires 40 may be connected to different electrodes among the plurality of electrodes 20 and the second ends of the plurality of bonding wires 40 may be connected to any bonding pad among the plurality of bonding pads 30. Based on the same reason as that in the seventh embodiment (which will not be described repeatedly here), the normality of the whole wafer circuit will not be affected even if an electrode 20 is damaged, or a bonding pad 30 is separated or a bonding wire 40 is damaged.

Optionally, in an embodiment of the present invention, when the electrode 20 is a plurality of electrodes 20, the plurality of electrodes 20 may be arranged at a P type material side of the wafer 10 simultaneously, or arranged at an N type material side of the wafer 10 simultaneously.

The above are only preferred embodiments of the present invention, but are not used for limiting the present invention. For those skilled in the art, the present invention may have various modifications and changes. Any modifications, equivalent replacements, improvements and the like made within the spirit and principles of the present invention shall be included in the scope of protection of the present invention.

## Claims

1. A wafer circuit, comprising:
a wafer, fixed on a substrate;
an electrode, arranged on the wafer;
a bonding pad, arranged on the substrate; and
a plurality of bonding wires with first ends all connected to the electrode and second ends all connected to the bonding pad, wherein the plurality of bonding wires are parallel bonding wires.

2. The wafer circuit according to claim 1, wherein the electrode is one electrode and the bonding pad is one bonding pad,
the first ends of the plurality of bonding wires are all connected to the electrode and the second ends of the plurality of bonding wires are all connected to the bonding pad includes: the first ends of the plurality of bonding wires are all connected to the one electrode and the second ends of the plurality of bonding wires are all connected to the one bonding pad.

3. The wafer circuit according to claim 1, wherein the electrode is one electrode and the bonding pad is a plurality of bonding pads,
the first ends of the plurality of bonding wires are all connected to the electrode and the second ends of the plurality of bonding wires are all connected to the bonding pad includes: the first ends of the plurality of bonding wires are all connected to the one electrode and the second ends of the plurality of bonding wires are connected to any one bonding pad among the plurality of bonding pads.

4. The wafer circuit according to claim 1, wherein the electrode is one electrode and the bonding pad is a plurality of bonding pads,
the first ends of the plurality of bonding wires are all connected to the electrode and the second ends of the plurality of bonding wires are all connected to the bonding pad includes: the first ends of the plurality of bonding wires are all connected to the one electrode and the second ends of the plurality of bonding wires are connected to different bonding pads among the plurality of bonding pads.

5. The wafer circuit according to claim 1, wherein the electrode includes a first electrode and a second electrode, the bonding pad includes a first bonding pad and a second bonding pad, and the plurality of bonding wires include a first bonding wire and a second bonding wire,
the first ends of the plurality of bonding wires are all connected to the electrode and the second ends of the plurality of bonding wires are all connected to the bonding pad includes: a first end of the first bonding wire is connected to the first electrode, a second end of the first bonding wire is connected to the first bonding pad, a first end of the second bonding wire is connected to the second electrode and a second end of the second bonding wire is connected to the second bonding pad.

6. The wafer circuit according to claim 1, wherein the electrode is a plurality of electrodes, and the bonding pad is one bonding pad,
the first ends of the plurality of bonding wires are all connected to the electrode and the second ends of the plurality of bonding wires are all connected to the bonding pad includes: the first ends of the plurality of bonding wires are connected to any electrode among the plurality of electrodes, and the second ends of the plurality of bonding wires are all connected to the one bonding pad.

7. The wafer circuit according to claim 1, wherein the electrode is a plurality of electrodes, and the bonding pad is one bonding pad,
the first ends of the plurality of bonding wires are all connected to the electrode and the second ends of the plurality of bonding wires are all connected to the bonding pad includes: the first ends of the plurality of bonding wires are connected to different electrodes among the plurality of electrodes and the second ends of the plurality of bonding wires are all connected to the one bonding pad.

8. The wafer circuit according to claim 1, wherein the electrode is a plurality of electrodes, and the bonding pad is a plurality of bonding pads,
the first ends of the plurality of bonding wires are all connected to the electrode and the second ends of the plurality of bonding wires are all connected to the bonding pad includes: the first ends of the plurality of bonding wires are connected to any electrode among the plurality of electrodes, and the second ends of the plurality of boding wires are connected to any bonding pad among the plurality of bonding pads.

9. The wafer circuit according to claim 1, wherein the electrode is a plurality of electrodes, and the bonding pad is a plurality of bonding pads,
the first ends of the plurality of bonding wires are all connected to the electrode and the second ends of the plurality of bonding wires are all connected to the bonding pad includes: the first ends of the plurality of bonding wires are connected to different electrodes among the plurality of electrodes and the second ends of the plurality of bonding wires are connected to different bonding pads among the plurality of bonding pads.

10. The wafer circuit according to claim 1, wherein the electrode is a plurality of electrodes, and the bonding pad is a plurality of bonding pads,
the first ends of the plurality of bonding wires are all connected to the electrode and the second ends of the plurality of bonding wires are all connected to the bonding pad includes: the first ends of the plurality of bonding wires are connected to any electrode among the plurality of electrodes and the second ends of the plurality of bonding wires are connected to different bonding pads among the plurality of bonding pads.

11. The wafer circuit according to claim 1, wherein the electrode is a plurality of electrodes, and the bonding pad is a plurality of bonding pads,
the first ends of the plurality of bonding wires are all connected to the electrode and the second ends of the plurality of bonding wires are all connected to the bonding pad includes: the first ends of the plurality of bonding wires are connected to different electrodes among the plurality of electrodes and the second ends of the plurality of bonding wires are connected to any bonding pad among the plurality of bonding pads.

12. The wafer circuit according to any one of claims 5 to 11, wherein the electrodes are arranged at a P type material side of the wafer simultaneously, or arranged at an N type material side of the wafer simultaneously.
